(19) Europäisches Patentamt

European Patent Office

Office européen des brevets

(11) Veröffentlichungsnummer: **0 389 846 B1**

(12) **EUROPÄISCHE PATENTSCHRIFT**

(45) Veröffentlichungstag der Patentschrift: **01.06.94**

(51) Int. Cl.⁵: **H02M 3/07**, G11C 16/06

(21) Anmeldenummer: **90104501.3**

(22) Anmeldetag: **09.03.90**

(54) **Spannungsvervielfacherschaltung.**

(30) Priorität: **25.03.89 DE 3909945**
**22.09.89 DE 3931596**

(43) Veröffentlichungstag der Anmeldung:
**03.10.90 Patentblatt 90/40**

(45) Bekanntmachung des Hinweises auf die
Patenterteilung:
**01.06.94 Patentblatt 94/22**

(84) Benannte Vertragsstaaten:
**DE FR GB IT NL**

(56) Entgegenhaltungen:
**WO-A-86/06539**
**DE-A- 2 812 908**

**ELECTRONIC DESIGN 18 August 1983, New
Jersey, US Seiten 189 - 196; F. Jones et al.:
"EEPROM adapts easily to in-systems changes"**

(73) Patentinhaber: **EUROSIL electronic GmbH
Erfurter Strasse 16
D-85386 Eching(DE)**

(72) Erfinder: **Lingstaedt, Ernst
Herzog-Arnulf-Strasse 10
D-8011 Zorneding(DE)**
Erfinder: **Miller, Paul
Treitschkestrasse 17
D-8000 München 50(DE)**

(74) Vertreter: **Maute, Hans-Jürgen, Dipl.-Ing.
TEMIC TELEFUNKEN microelectronic GmbH,
Postfach 35 35
D-74025 Heilbronn (DE)**

Rank Xerox (UK) Business Services
(3.10/3.09/3.3.3)

## Beschreibung

Die Erfindung betrifft eine Spannungsvervielfacherschaltung gemäß dem Oberbegriff des Anspruches 1.

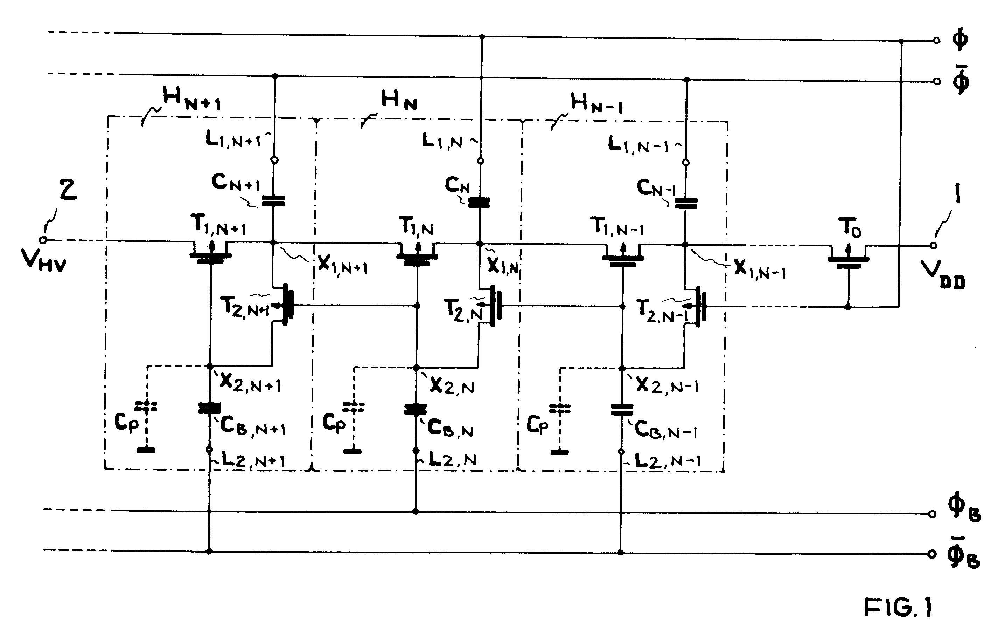

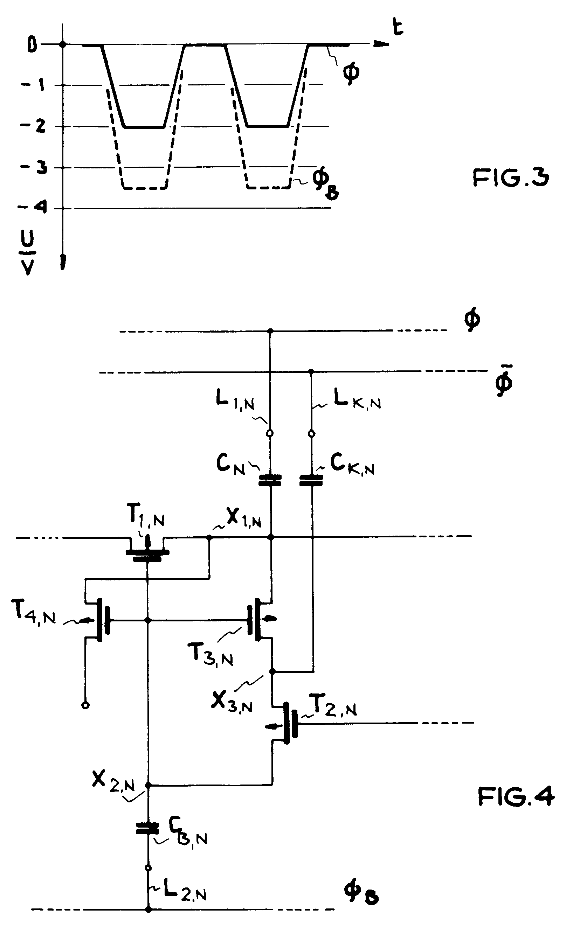

Eine solche Schaltung ist aus der Zeitschrift Electronic Design, 18. August 1983, Seiten 189 bis 196, insbesondere Figur 3a bekannt. Eine solche Schaltung dient zum Erzeugen einer Programmier- und Löschspannung von elektrisch löschbaren, nichtflüchtigen Speicherelementen (EEPROM), die über der Versorgungsspannung von 5 V, in der Größenordnung von 20 V liegen. Eine solche Schaltung zeigt die Figur 1, die aus mehreren Spannungsvervielfacherstufen $H_N$ aufgebaut ist, wobei drei Stufen $H_{N-1}$, $H_N$ und $H_{N+1}$ gezeichnet sind. Darüber hinaus kann eine solche Spannungsvervielfacherschaltung weitere Stufen enthalten, deren Anzahl von der Höhe der zu erzeugenden Spannung abhängt.

Im folgenden soll diese Schaltung beschrieben und deren Funktionsweise im eingeschwungenen Zustand erläutert werden.

Die gesamte Schaltung ist in MOS-Technologie ausgeführt, wobei die MOS-Feldeffekttransistoren (MOS-FET) als p-Kanaltyp ausgebildet sind. Jede Spannungsvervielfacherstufe $H_{N-1}$, $H_N$ und $H_{N+1}$ ist jeweils aus zwei MOS-Transistoren sowie zwei MOS-Kondensatoren aufgebaut, die mit $T_{1,N-1}$ und $T_{2,N-1}$, $T_{1,N}$ und $T_{2,N}$ sowie mit $T_{1,N+1}$ und $T_{2,N+1}$ bzw. mit $C_{N-1}$ und $C_{B,N-1}$, $C_N$ und $C_{B,N}$ sowie mit $C_{N+1}$ und $C_{B,N+1}$ bezeichnet sind. Die Verschaltung dieser Elemente soll nun an der Stufe $H_N$ erläutert werden. Die Source-Elektrode des ersten Transistors $T_{1,N}$ ist über einen ersten Summationspunkt $X_{1,N}$ sowohl mit der ersten Anschlußelektrode des ersten Kondensators $C_N$ als auch mit der Source-Elektrode des zweiten Transistors $T_{2,N}$ verbunden und zusätzlich noch mit der Drain-Elektrode des ersten Transistors $T_{1,N-1}$ der vorangehenden Stufe $H_{N-1}$, während die Drain-Elektrode des ersten Transistors $T_{1,N}$ an dem ersten Summationspunkt $X_{1,N+1}$ der nachgeschalteten Stufe $H_{N+1}$ angeschlossen ist. Die zweite Anschlußelektrode des ersten Kondensators $C_N$ ist an eine ein erstes Taktsignal $\phi$ liefernde erste Taktleitung $L_{1,N}$ angeschlossen. Ferner ist ein die Drain-Elektrode des zweiten Transistors $T_{2,N}$ mit der Gate-Elektrode des ersten Transistors $T_{1,N}$ verbindender zweiter Summationspunkt $X_{2,N}$ über den zweiten Kondensator $C_{B,N}$ mit einer ein zweites Taktsignal $\phi_B$ liefernde zweite Taktleitung $L_{2,N}$ verbunden. Schließlich ist noch der zweite Summationspunkt $X_{2,N}$ an die Gate-Elektrode des zweiten Transistors $T_{2,N+1}$ der nachgeschalteten Stufe $H_{N+1}$ angeschlossen.

Der Eingang 1 ist mit der Source-Elektrode eines Eingangstransistors $T_O$ verbunden, während dessen Drain-Elektrode auf den ersten Summationspunkt $X_{1,N-1}$ der ersten Stufe $H_{N-1}$ geführt ist. Die Gate-Elektrode dieses Transistors $T_O$ wird über eine Leitung mit dem Taktsignal $\phi$ versorgt. Dem Eingang 1 wird die zu vervielfachende Spannung, vorzugsweise die Betriebsspannung $V_{DD}$ zugeführt. Die vervielfachte Ausgangsspannung $V_{HV}$ ist dann am Ausgang 2 abgreifbar.

Aufeinanderfolgende Stufen $H_N$ und $H_{N+1}$ werden mit ersten Taktsignalen $\phi$ und $\overline{\phi}$ versorgt, die gegenphasig zueinander sind. Ebenso sind die entsprechenden zweiten Taktsignale $\phi_B$ und $\overline{\phi}_B$ gegenphasig. Der Spannungshub des ersten Taktsignales $\phi$ bzw. $\overline{\phi}$ ist üblicherweise so groß wie die zur Verfügung stehende Versorgungsspannung, im Beispiel 5 V, während derjenige des zweiten Taktsignales $\phi_B$ bzw. $\overline{\phi}_B$. Um einige Volt größer ist, beispielsweise 8,5 V, wobei jedoch alle Spannungen negativ sind und das Bezugspotential Null Volt beträgt.

Wie schon oben erwähnt, ist diese Spannungsvervielfacherschaltung als integrierte MOS-Schaltung mit p-Kanalfeldeffekttransistoren ausgeführt, so daß das Substrat auf dem Potential der Source-Elektroden dieser Feldeffekttransistoren liegt. Hierdurch entstehen zwischen dem Source- bzw. dem Drain-Bereich jedes Transistors und dem Substrat parasitäre Kapazitäten, die in dem Schaltbild gemäß Figur 1 mit $C_p$ bezeichnet sind.

Die Spannungsvervielfachung kommt dadurch zustande, daß Ladungen von einer Stufe zur nächstfolgenden mittels der ersten Kondensatoren $C_1$, $C_2$, ... $C_N$, ..., $C_{N+m}$ (m O) übertragen werden, weshalb diese Kondensatoren auch als Pumpkondensatoren bezeichenbar sind. Angenommen, der Pumpkondensator $C_N$ der Stufe $H_N$ erhält von dem Pumpkondensator $C_{N-1}$ der vorhergehenden Stufe $H_{N-1}$ über deren leitenden ersten Transistor $T_{1,N-1}$ eine gewisse Ladungsmenge, wobei am Pumpkondensator $C_N$ der High-Pegel ($V_\phi$ = 0 V) des Taktsignales $\phi$ und an der vorhergehenden Stufe $H_{N-1}$ der Low-Pegel ($V_{\overline{\phi}}$ = - 5 V) des Taktsignales $\overline{\phi}$ anliegt. Der erste Transistor $T_{1,N}$ der Stufe $H_N$ muß gesperrt sein, wobei dies dadurch erfolgt, daß der zweite Transistor dieser Stufe $H_N$ leitend ist, da deren Gate-Source-Spannung derjenigen des Transistors $T_{1,N-1}$ entspricht. Daher entspricht die Gate-Source-Spannung an dem Transistor $T_{1,N}$ 0 V, das heißt, dieser Transistor ist im gesperrten Zustand. Der zweite Kondensator $C_{B,N}$ der Stufe $H_N$ liegt zu diesem Zeitpunkt auf dem High-Pegel ($V_{\phi B}$ = 0 V) des Taktsignales $\phi_B$, während demjenigen der vorangehenden Stufe $H_{N-1}$ der Low-Pegel ($V_{\overline{\phi}B}$ = - 8,5 V) zugeführt ist.

Der Spannungspegel von - 8,5 V wird mittels einer Spannungsverdopplerschaltung erzeugt. Während des Umladevorganges von dem Kondensator $C_{N-1}$ auf $C_N$ liegt beispielsweise der erste Summationspunkt $X_{1,N}$ der Stufe $H_N$ auf einem Potential von ca. - 5 V (und damit auch der erste Summationspunkt $X_{1,N-1}$ der vorhergehenden Stufe $H_{N-1}$) und der erste Summationspunkt $X_{1,N+1}$ der nachfolgenden Stufe $H_{N+1}$ auf ca. - 15 V.

Schaltet nun der Takt zur nächsten Phase weiter, liegt der zweite Kondensator $C_{B,N}$ der Stufe $H_N$ auf dem Low-Pegel ($V_{\overline{\phi}B}$ = - 8,5 V) des Taktsignales $\overline{\phi}_B$, wodurch der erste Transistor $T_{1,N}$ in den leitenden Zustand übergeht. Der Pumpkondensator $C_N$ erhält ebenfalls den Low-Pegel des Taktsignals $\phi$, so daß der erste Summationspunkt $X_{1,N}$ der Stufe $H_N$ von ca. - 5 V auf ca. - 10 V gezogen wird. Der zweite Transistor $T_{2,N}$ der Stufe $H_N$ wird dagegen gesperrt, da das Potential am zweiten Summationspunkt $X_{2,N-1}$ der vorangehenden Stufe $H_{N-1}$ aufgrund des an dem zweiten Kondensator $C_{B,N-1}$ anliegenden High-Pegels ansteigt, womit gleichzeitig auch der erste Transistor $T_{1,N-1}$ der vorangehenden Stufe $H_{N-1}$ in den sperrenden Zustand übergeht. Die Ladung des Pumpkondensators $C_N$ wird somit auf den Pumpkondensator $C_{N+1}$ der nächsten Stufe $H_{N+1}$ übertragen, das heißt der erste Summationspunkt $X_{1,N+1}$ dieser nächsten Stufe liegt ebenfalls auf ca. - 10 V. Der nächste Taktimpuls $\overline{\phi}$ zieht nun den Spannungspegel an diesem ersten Summationspunkt $X_{1,N+1}$ auf ca. - 15 V, während der Spannungspegel am ersten Summationspunkt $X_{1,N}$ der Stufe $H_N$ durch diesen Taktwechsel auf ca. - 5 V zurückgeht. Die Transistoren der beiden Stufen $H_{N+1}$ und $H_N$ schalten entsprechend wie zuvor beschrieben.

Um den Spannungsabfall an dem ersten Transistor $T_{1,N}$ der Stufe $H_N$ beim Ladungstransport von dem Kondensator $C_N$ auf den Kondensator $C_{N+1}$ so gering als möglich zu halten, muß die Spannungsdifferenz $\Delta V$ zwischen dem ersten Summationspunkt $X_{1,N}$ und dem zweiten Summationspunkt $X_{2,N}$ größer sein als die Summe aus der Schwellspannung und der Schwellspannungsverschiebung. Die Schwellspannungsverschiebung tritt aufgrund des Substrateffektes auf. Da die Absolutwerte der Spannungspegel an den ersten und zweiten Summationspunkten von Stufe zu Stufe immer größer werden, muß die Spannungsdifferenz $\Delta V$ ausreichend groß sein, um auch bei einer Substratvorspannung von beispielsweise - 20 V der letzten Stufe noch einen genügend kleinen Spannungsabfall über dem ersten Transistor sicherzustellen. Bei einer Versorgungsspannung $V_{DD}$ von 5 V läßt sich unter Verwendung einer integrierten Spannungsverdopplerschaltung zur Erzeugung der zweiten Taktspannung $V_{\phi B}$ bzw. $V_{\overline{\phi}B}$ ein ausreichender Wert für die Spannungsdifferenz $\Delta V$ realisieren.

Liegt jedoch die Versorgungsspannung $V_{DD}$ wesentlich unter 5 V, beträgt sie beispielsweise 2 V, so läßt sich mit vertretbarem Aufwand keine ausreichende Spannungsdifferenz $V$ erzeugen, da in der Spannungsverdopplerschaltung eine große Pumpkapazität erforderlich wäre. Dies ließe sich jedoch dadurch umgehen, daß zur Erzeugung einer höheren Taktspannung $V_{\phi B}$ bzw. $V_{\overline{\phi}B}$ eine Spannungsverdreifacherschaltung anstelle einer Spannungsverdopplerschaltung einzusetzen wäre. Eine solche Lösung weist allerdings ebenfalls eine Reihe von Nachteilen auf, da eine Spannungsverdreifacherschaltung wesentlich mehr Bauteile erfordert sowie mehr integrierte und große Pumpkondensatoren benötigt werden. Schließlich führt die Erzeugung der Taktspannung $V_{\phi B}$ und $V_{\overline{\phi}B}$ aus einer höheren Spannung durch unvermeidbare Umladeverluste parasitärer Kapazitäten auch zu einer erhöhten Stromaufnahme.

Auch aus der Druckschrift WO 86/06539 ist eine Spannungsvervielfacherschaltung bekannt, die ebenfalls lediglich bei einer Versorgungsspannung von wenigstens + 5 V zufriedenstellend arbeitet. Die einzelnen Stufen dieser bekannten Schaltung sind in ähnlicher Weise wie diejenigen nach Figur 1 aufgebaut, insbesondere enthalten sie auch einen ersten p-MOS-Transistor, der den Eingang der Stufe mit deren Ausgang verbindet, ebenfalls einen zweiten p-MOS-Transistor, dessen Source-Drain-Strecke entsprechend der Schaltung nach Figur 1 die Gate-Elektrode des ersten Transistors mit dem Eingang der Stufe verbindet. Ferner ist auch ein Pumpkondensator vorgesehen, der jedoch an den Ausgang der Stufe angeschlossen ist. Schließlich weist diese bekannte Stufe noch einen dritten Transistor sowie einen zweiten und dritten Kondensator auf. Die Aufgabe des zweiten Transistors der bekannten Stufe entspricht derjenigen der Schaltung nach Figur 1, nämlich den ersten Transistor im gesperrten Zustand zu halten, indem die Gate- als auch die Source-Elektrode auf das gleiche Potential gelegt werden. Somit muß auch bei einer Spannungsvervielfacherschaltung mit mehreren solcher bekannten Stufen an jeder einzelnen dieser Stufen eine ausreichende Spannungsdifferenz $V$ erzeugt werden, um den Spannungsabfall an den ersten Transistoren gering zu halten.

Der Erfindung liegt daher die Aufgabe zugrunde, eine Spannungsvervielfacherschaltung der eingangs genannten Art anzugeben, die mit einer Betriebsspannung arbeitet, die wesentlich unter 5 V liegt und einen minimalen Energieverbrauch aufweist sowie keinen erhöhten Schaltungsaufwand erforderlich macht.

Diese Aufgabe wird durch die kennzeichnenden Merkmale des Anspruches 1 gelöst.

Bei einer Spannungsvervielfacherschaltung gemäß der Erfindung wird die Gate-Source-Spannung des ersten Transistors jeder Stufe zum Sperren dieses Transistors nicht auf den Wert 0 geregelt, wie bei der Schaltung nach Figur 1, sondern es ist ein dritter MOS-Transistor sowie ein dritter MOS-Kondensator vorgesehen, wobei die Gate- und die Source-Elektrode dieses dritten MOS-Transistors jeweils auf dem gleichen Potential wie die Gate- und Source-Elektrode des ersten MOS-Transistors liegen und der dritte MOS-Kondensator so geschaltet ist, daß seine gespeicherte Ladung so lange über den ersten MOS-Transistor abfließen kann, bis über dessen Source-Drain-Strecke eine Spannungsdifferenz abfällt, deren Wert der Summe der Schwellspannung und der Schwellspannungsverschiebung des ersten MOS-Transistors entspricht oder diese Summe geringfügig unterschreitet.

Dadurch ist für das Taktsignal $\phi_B$ bzw. $\overline{\phi}_B$ nur ein geringfügiger Signalhub erforderlich, weshalb zu deren Erzeugung eine Spannungsverdopplerschaltung ausreicht, die keinen großen Schaltungsaufwand und keine großen integrierten Pumpkondensatoren erforderlich macht.

Ein besonderer Vorteil der Erfindung besteht darin, daß prozeßbedingte Schwankungen der Schwellspannung und der Schwellspannungsverschiebung aufgrund des Substrateffektes kompensiert werden.

Ferner ist gemäß der Weiterbildung nach Anspruch 2 der zusätzliche Schaltungsaufwand gegenüber der bekannten Schaltung gemäß der Figur 1 gering, da jede Stufe zusätzlich nur einen Transistor und einen Kondensator mit kleiner Kapazität enthält.

Bei einer vorteilhaften Ausgestaltung der Erfindung wird die Korrektursignalleitung mit einem konstanten Betriebsspannungspotential beaufschlagt. Hierdurch beträgt die maximal erreichbare Kompensation der Schwellspannung und der Schwellspannungsverschiebung dem Wert des Spannungshubes an dem ersten Kondensator jeder Stufe.

Die Korrektursignalleitung kann auch gemäß einer anderen Weiterbildung der Erfindung mit der ersten Taktsignalleitung verbunden werden, wodurch der dritte Kondensator einer Stufe mit dem ersten Taktsignal beaufschlagt wird, das zu dem Taktsignal, das den ersten Kondensator dieser Stufe ansteuert, gegenphasig ist. Damit kann die Kompensation von der Schwellspannung und der Schwellspannungsverschiebung bis zu einem Wert erfolgen, das dem doppelten Wert des Spannungshubes an dem ersten Kondensator einer Stufe entspricht.

Gemäß einer weiteren erfindungsgemäßen Weiterbildung der Schaltung wird zum Abgriff einer Zwischenspannung entlang der Spannungsvervielfacherschaltung die entsprechende Stufe mit einem vierten MOS-Transistor versehen, wobei die Source-Elektrode des vierten MOS-Transistors mit dem ersten Summationspunkt und dessen Gate-Elektrode mit dem zweiten Summationspunkt verbunden ist, und die Zwischenspannung an der Drain-Elektrode dieses vierten MOS-Transistors abgreifbar ist.

Bei einer vorteilhaften Weiterbildung der Erfindung werden einige der letzten Stufen einer Spannungsvervielfacherschaltung mit Transistoren vom entgegengesetzten Leitfähigkeitstyp aufgebaut, insbesondere vom n-Kanaltyp, während die ersten Stufen mit Transistoren vom p-Kanaltyp sind. Hierbei werden die zweiten MOS-Transistoren dieser letzten Stufen so verschaltet, daß deren Gate-Elektroden jeweils mit dem zugehörigen ersten Summationspunkt und deren Source-Elektroden jeweils mit der Drain-Elektrode des zugehörigen ersten MOS-Transistors verbunden sind. Hierdurch wird vermieden, daß bei mit p-Kanaltransistoren aufgebauten Spannungsvervielfacherschaltungen mit hoher Ausgangsspannung die Durchbruchspannung der Drain-Substrat-Diode des zweiten Transistors der letzten Stufe erreicht wird.

Die Erfindung ist nachfolgend anhand eines Ausführungsbeispieles einer Spannungsvervielfacherschaltung näher erläutert. Es zeigen:

Die Figur 2 ein Schaltbild eines Ausführungsbeispieles einer Spannungsvervielfacherschaltung gemäß der Erfindung,

die Figur 3 ein Diagramm der Taktsignale $\phi$ und $\phi_B$,

Figur 4 ein Ausführungsbeispiel einer Schaltung zum Abgriff einer Zwischenspannung, und

Figur 5 ein Schaltbild eines weiteren Ausführungsbeispieles einer Spannungsvervielfacherschaltung gemäß der Erfindung.

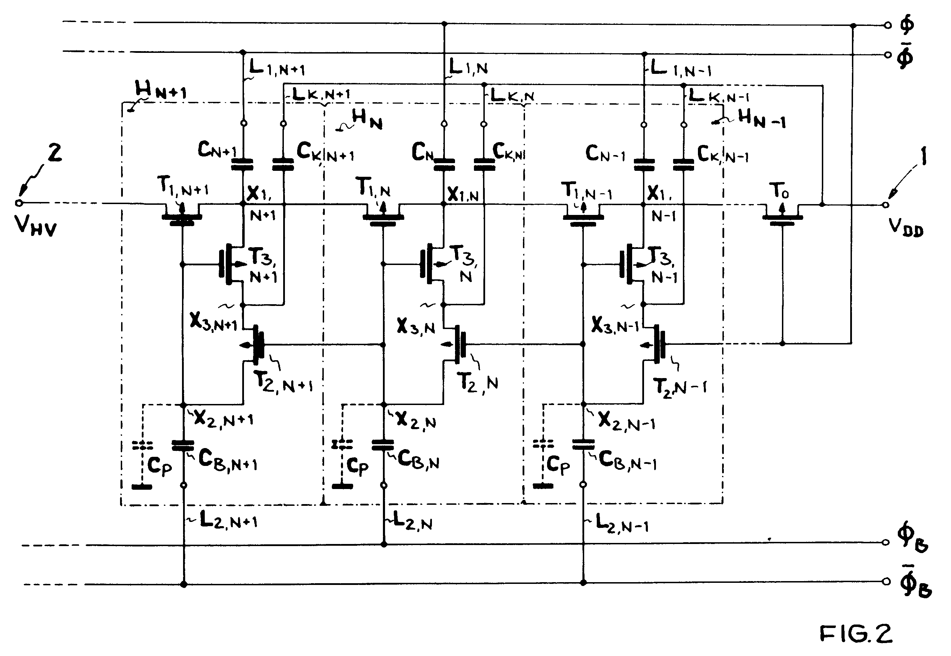

Bei der Spannungsvervielfacherschaltung nach Figur 2 bezeichnet $H_{N-1}$, $H_N$ und $H_{N+1}$ jeweils eine Stufe entsprechend der Schaltung nach Figur 1. Die Funktion der ersten und zweiten Transistoren sowie der ersten und zweiten Kondensatoren der einzelnen Stufen wurde schon bei der Erläuterung der Schaltung nach Figur 1 beschrieben.

Dort wurde ausgeführt, daß zum Sperren des ersten Transistors einer Stufe, beispielsweise des Transistors $T_{1,N}$ der Stufe $H_N$, dessen Gate-Source-Spannung Null wird. Da jedoch die Schwellspannung dieser Transistoren aufgrund des Substrateffektes bis zu 4 V betragen kann, reicht es zum sicheren Sperren dieses ersten Transistors $T_{1,N}$ aus, die Gate-Source-Spannung gerade so groß zu machen, daß sie die Summe aus der Schwellspannung und der Schwellspannungsverschiebung erreicht oder geringfügig unterschreitet. Hierzu dient in jeder Stufe $H_{N-1}$, $H_N$ und $H_{N+1}$ ein zusätzlicher dritter Transistor und ein zusätzlicher dritter Kondensator, also in der Figur 2 die Transistoren $T_{3,N-1}$, $T_{3,N}$ und $T_{3,N+1}$ sowie die Kondensatoren $C_{K,N-1}$, $C_{K,N}$ und $C_{K,N+1}$. Die Schaltung gemäß Figur 2 entspricht somit bis auf diese zusätzlichen Elemente der bekannten Schaltung nach Figur 1.

Die Erläuterung der Verschaltung dieser zusätzlichen Elemente erfolgt nun am Beispiel der Stufe $H_N$ der Schaltung nach Figur 2. Hiernach verbindet der dritte Transistor $T_{3,N}$ mit seiner Source-Drain-Strecke den ersten Summationspunkt $X_{1,N}$ mit der Source-Elektrode des zweiten Transistors $T_{2,N}$ der Stufe $H_N$, während dessen Gate-Elektrode mit der Gate-Elektrode des ersten Transistors $T_{1,N}$ der gleichen Stufe verbunden ist. Der Summationspunkt zwischen der Drain-Elektrode des neuen dritten Transistors $T_{3,N}$ und der Source-Elektrode des zweiten Transistors $T_{2,N}$ der Stufe $H_N$ ist der dritte Summationspunkt und ist mit $X_{3,N}$ bezeichnet. Der dritte Kondensator $C_{K,N}$ ist mit seiner ersten Anschlußelektrode mit diesem dritten Summationspunkt $X_{3,N}$ verbunden und liegt mit seiner zweiten Anschlußelektrode über eine Korrektursignalleitung $L_{K,N}$ auf dem Betriebspotential $V_{DD}$. Die anderen beiden Stufen $H_{N-1}$ und $H_{N+1}$ sind entsprechend aufgebaut. Neben den in der Schaltung dargestellten drei Stufen kann eine Spannungsvervielfacherschaltung darüber hinaus noch mehr Stufen enthalten.

Im folgenden soll die Funktion der Schaltung gemäß Figur 2 erklärt werden. Hierbei beträgt der High- bzw. Low-Pegel des Taktsignales $\phi$ 0 bzw. - 2 V, während der High-bzw. Low-Pegel des Taktsignales $\phi_B$ 0 bzw. - 3,5 V beträgt. Beim Ladungstransport von dem Kondensator $C_N$ der Stufe $H_N$ auf den Kondensator $C_{N+1}$ der Stufe $H_{N+1}$ ist sowohl das Taktsignal $\phi$ als auch das Taktsignal $\phi_B$ auf Low-Pegel, während das Taktsignal $\overline{\phi_B}$ auf High-Pegel ist. Der Transistor $T_{1,N}$ ist während dieser Taktphase leitend, also ist die Spannungsdifferenz $\Delta V$ zwischen dem ersten Summationspunkt $X_{1,N}$ und dem zweiten Summationspunkt $X_{2,N}$ größer als die Summe aus der Schwellspannung und der Schwellspannungsverschiebung. Da der Transistor $T_{1,N}$ leitet, ist auch der Transistor $T_{3,N}$ leitend, da an beiden die gleiche Gate- Source-Spannung anliegt. Deshalb liegt der dritte Summationspunkt $X_{3,N}$ auf dem Potential des ersten Summationspunktes $X_{1,N}$. Das bei der Erläuterung der Schaltung der Figur 1 angenommene Potential an den ersten Summationspunkten $X_{1,N}$ und $X_{1,N+1}$ der Stufen $H_N$ und $H_{N+1}$ betrage auch hier ca. - 10 V. Somit wird der Kondensator $C_{K,N}$ auf dieses Potential von ca. - 10 V aufgeladen. Der Transistor $T_{2,N}$ ist zu diesem Zeitpunkt gesperrt. Der zweite Summationspunkt $X_{2,N}$ liegt auf einem Potential von ca. - 12,5 V.

Beim Übergang zur nächsten Taktphase, bei der die beiden Taktsignale $\phi$ und $\phi_B$ auf High-Pegel sind, das Taktsignal $\overline{\phi}$ aber auf Low-Pegel, entlädt sich der Kondensator $C_{K,N}$ in Richtung des ersten Summationspunktes $X_{1,N}$ auf ein Potential, dessen Wert um die Summe aus der Schwellspannung und der Schwellspannungsverschiebung unter dem Potential an dem ersten Summationspunkt $X_{1,N}$ liegt. Das bedeutet aber, daß bei diesem Wert die Entladung des Kondensators $C_{K,N}$ stoppt, da dann der Transistor $T_{3,N}$ und somit auch der Transistor $T_{1,N}$ in den sperrenden Zustand übergeht. Nun erfolgt ein Ladungstransport von dem Kondensator $C_{N-1}$ der Stufe $H_{N-1}$ auf den Kondensator $C_N$ der Stufe $H_N$, wobei die Summationspunkte $X_{1,N-1}$ und $X_{1,N}$ auf einem Potential von - 8 V liegen Da zu diesem Zeitpunkt der zweite Transistor $T_{2,N}$ der Stufe $H_N$ leitet, liegen der zweite und dritte Summationspunkt $X_{2,N}$ und $X_{3,N}$ auf gleichem Potential von ungefähr - 9 V. Die Summe aus der Schwellspannung und der Schwellspannungsverschiebung beträgt in diesem Fall also ca. 1 V.

Da die Gate-Source-Spannung des Transistors $T_{1,N}$ beim Übergang in den sperrenden Zustand durch die Entladung des Kondensators $C_{K,N}$ nur soweit reduziert wird, daß dieser Transistor gerade sperrt, werden prozeßbedingte Schwankungen der Schwellspannung und der Schwellspannungsverschiebung kompensiert. Der zusätzliche Schaltungsaufwand pro Stufe ist dagegen aber sehr gering, da er nur aus einem zusätzlichen MOS-Transistor $T_{3,N}$ mitMinimaldimensionen sowie einem zusätzlichen Kondensator $C_{K,N}$ mit kleiner Kapazität von vorzugsweise 0,2 pF besteht.

Da dieser Wert für den Kondensator $C_{K,N}$ im Vergleich zu demjenigen des Pumpkondensators $C_N$ (vorzugsweise 5 pF) sehr klein ist, sind keine nachteiligen Wirkungen auf die Funktion der Schaltung zu erwarten. Ferner ist für das Taktsignal $\phi_B$ nur ein geringer Signalhub erforderlich, um den Transistor $T_{1,N}$ wieder leitend zu steuern. Es ist ausreichend, wenn der Pegel des Taktsignales $\phi_B$ um ca. 1 V negativer liegt als derjenige des Taktsignales $\phi$. Die Figur 3 zeigt ein Beispiel für die Spannungspegel der Taktsignale $\phi$ und $\phi_B$ bei einer Betriebsspannung $V_{DD}$ von - 2 V, wobei der Low-Pegel für das Taktsignal $\phi$ - 2 V und für das Taktsignal $\phi_B$ - 3,5 V beträgt. Diese Spannungsüberhöhung von ca. 1,5 V läßt sich ohne großen Schaltungsaufwand mit einer integrierten Spannungsverdopplerschaltung realisieren, die auch keine großen integrierten Pumpkondensatoren erfordert.

Gemäß der Figur 2 sind die zusätzlichen Kondensatoren $C_{K,N-1}$, $C_{K,N}$ und $C_{K,N+1}$ der Stufen $H_{N-1}$, $H_N$ und $H_{N+1}$ mit jeweils einer Korrektursignalleitung $L_{K,N-1}$, $L_{K,N}$ und $L_{K,N+1}$ verbunden, die wiederum auf dem Betriebspotential $V_{DD}$ liegt. Hierdurch ist die maximal erreichbare Kompensation von Schwellspannung und Schwellspannungsverschiebung gleich der Höhe des Spannungshubes an den Pumpkondensatoren $C_{N-1}$, $C_N$ und $C_{N+1}$. Wäre beispielsweise der Wert der Summe aus der Schwellspannung und der Schwellspannungsverschiebung größer als 2 V, so würde sich beispielsweise der Kondensator $C_{K,N}$ der Stufe $H_N$ nicht entladen, sondern der dritte Summationspunkt $X_{3,N}$ würde auf einem Potential von ca. - 10 V stehenbleiben. In diesem Fall würde also der zusätzliche Kondensator $C_{K,N}$ nichtumgeladen, wodurch die Spannungsvervielfacherschaltung durch diesen Kondensator $C_{K,N}$ nicht zusätzlich belastet wird. Falls die erforderliche Schwellspannungskompensation kleiner als der Signalhub an dem Kondensator $C_N$ der Stufe $H_N$ ist (also beispielsweise 1,5 V), wird der Kondensator $C_{K,N}$ in jedem Taktzyklus mit der Differenzspannung umgeladen, wobei die hierzu erforderliche Ladung vom vorhergehenden Pumpkondensator $C_{N-1}$ der Stufe $H_{N-1}$ aufgebracht wird. Hierdurch ergibt sich ein kleiner Spannungsverlust, der aber unter der Voraussetzung, daß die Kapazität des Kondensators $C_{K,N}$ wesentlich kleiner als diejenige des Pumpkondensator $C_N$ vernachlässigbar ist. Dieser Fall tritt jedoch nur dann auf, wenn die Schaltung optimale Eigenschaften aufweist, das heißt, niedrige Schwellspannung und geringen Substrateffekt zeigt, was in der Praxis in der Regel kaum auftritt.

Falls die Kompensation von Schwellspannung und Schwellspannungsverschiebung gemäß Figur 2 nicht ausreichend ist, kann der Kondensator $C_{K,N}$ der Stufe $H_N$ statt von einem festen Potential auch von einem zum Summationspunkt $X_{1,N}$ gegenphasigen Signal angesteuert werden. Wird beispielsweise der Kondensator $C_N$ der Stufe $H_N$ von dem Taktsignal $\phi$ angesteuert, so muß der Kondensator $C_{K,N}$ von dem gegenphasigen Taktsignal $\overline{\phi}$ angesteuert werden. Auf diese Weise kann eine Kompensation der Summe aus der Schwellspannung und der Schwellspannungsverschiebung bis zur doppelten Höhe des Spannungshubes an dem Kondensator $C_N$ erreicht werden. Diese Art der Ansteuerung ist für die Stufen einer Spannungsvervielfacherschaltung vorteilhaft, die sich nahe an der Ausgangsspannung befinden, wo der höchste Substrateffekt auftritt.

Wenn die Spannungsvervielfacherschaltung gemäß Figur 2 aus Transistoren eines Leitfähigkeitstyps - beispielsweise vom p-Kanaltyp - aufgebaut ist, kann beim zweiten Transistor der letzten Stufe der Spannungsvervielfacherschaltung die Durchbruchspannung der Drain-Substrat-Diode erreicht werden, falls hohe Ausgangsspannungen zu erzeugen sind. Beispielsweise muß bei einer Ausgangsspannung von ca. - 20 V die Gate-Elektrode des ersten Transistors einer letzten Stufe einer Spannungsvervielfacherschaltung noch um ca. 3,5 - 4 V negativer gezogen werden, um einen Spannungsverlust zu vermeiden. Dabei kann jedoch schon die erwähnte Durchbruchsspannung überschritten werden.

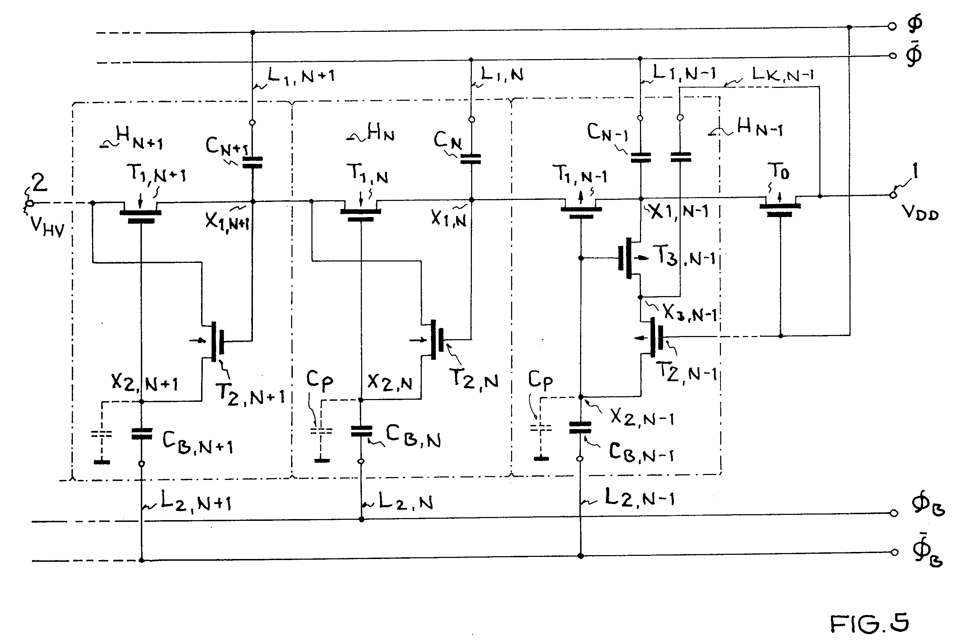

Um einen solchen Durchbruch zu vermeiden, können die Transistoren der letzten zwei oder drei Stufen einer Spannungsvervielfacherschaltung gemäß Figur 2 mit Transistoren vom entgegengesetzten Leitfähigkeitstyp, also vom n-Kanaltyp aufgebaut werden, wenn die vorhergehenden Stufen Transistoren vom p-Kanaltyp enthalten. Eine solche Spannungsvervielfacherstufe zeigt die Figur 5, wonach die erste Stufe $H_{N-1}$ p-Kanaltransistoren und die letzten beiden Stufen $H_N$ und $H_{N+1}$ n-Kanaltransistoren aufweisen. Hierbei unterscheiden sich jedoch diese letzten beiden Stufen $H_N$ und $H_{N+1}$ von der ersten Stufe $H_{N-1}$ in ihrem Aufbau. Diese Stufen enthalten jeweils nur zwei MOS-Transistoren $T_{1,N}$ und $T_{2,N}$ bzw. $T_{1,N+1}$ und $T_{2,N+1}$ vom n-Kanaltyp sowie jeweils einer ersten und einen zweiten Kondensator $C_N$ und $C_{B,N}$ bzw. $C_{N+1}$ und $C_{B,N+1}$. Diese Bauelemente sind entsprechend der ersten Stufe $H_{N-1}$ aufgebaut, wobei jedoch die Source- und Drain-Elektroden der ersten Transistoren $T_{1,N}$ und $T_{2,N}$ der beiden letzten Stufen $H_N$ und $H_{N+1}$ vertauscht sind, so daß jeweils die Drain-Elektrode der ersten Transistoren $T_{1,N}$ bzw. $T_{2,N}$ den ersten Summationspunkt $X_{1,N}$ bzw. $X_{2,N}$ bildet und die Source-Elektrode der ersten Transistoren $T_{1,N}$ der Stufe $H_N$ mit der Drain-Elektrode des ersten Transistors $T_{1,N+1}$ der Stufe $H_{N+1}$ verbunden ist und dessen Source-Elektrode den Ausgang der Stufe $H_{N+1}$ bildet. Die Verbindung der ersten Stufe $H_{N-1}$ mit der zweiten Stufe $H_N$ erfolgt über einen Anschluß der Drain-Elektrode des ersten Transistors $T_{1,N-1}$ der ersten Stufe $H_{N-1}$ mit der Drain-Elektrode des ersten Transistors $T_{1,N}$ der zweiten Stufe $H_N$. Die Gate-Elektrode des zweiten Transistors $T_{2,N}$ bzw. $T_{2,N+1}$ der zweiten bzw. dritten Stufe $H_N$ bzw. $H_{N+1}$ ist mit dem jeweiligen ersten Summationspunkt $X_{1,N}$ bzw. $X_{1,N+1}$ dieser Stufen $H_N$ bzw. $H_{N+1}$ verbunden, während dessen Drain-Elektrode an den jeweiligen zweiten Summationspunkt $X_{2,N}$ bzw. $X_{2,N+1}$ und dessen Source-Elektrode an die Source-Elektrode des jeweiligen ersten Transistors $T_{1,N}$ bzw. $T_{1,N+1}$ angeschlossen ist.

Im folgenden soll die Funktion dieser Schaltung gemäß Figur 5 erklärt werden. Hierzu sei angenommen, daß die Taktsignale $\phi$ und $\phi_B$ auf dem Low-Pegel (-2 V bzw. -3,5 V) und die Taktsignale $\overline{\phi}$ und $\overline{\phi}_B$ auf dem High-Pegel (0 V) liegen und ein Ladungstransport von dem Pumpenkondensator $C_{N-1}$ der ersten Stufe $H_{N-1}$ auf den Pumpenkondensator der zweiten Stufe $H_N$ erfolgen soll, weshalb der erste Transistor $T_{1,N-1}$ der ersten Stufe $H_{N-1}$ leitend ist. Zwangsläufig liegen daher die ersten Summationspunkte $X_{1,N-1}$ und $X_{1,N}$ der ersten und zweiten Stufe $H_{N-1}$ und $H_N$ auf dem gleichen Potential, beispielsweise auf -16 V. Das Potential des ersten Summationspunktes $X_{1,N+1}$ der letzten Stufe $H_{N+1}$ liegt demzufolge auf einem Potential von -20 V. Dies hat zur Folge, daß der zweite Transistor $T_{2,N}$ der zweiten Stufe $H_N$ leitet, weshalb die Gate-Source-Spannung des ersten Transistors $T_{1,N}$ der zweiten Stufe $H_N$ 0 V beträgt und er somit sperrt.

Beim Übergang zu nächsten Taktphase wechseln die Taktsignale $\phi$ und $\phi_B$ auf High-Pegel und die Taktsignale $\overline{\phi}$ und $\overline{\phi}_B$ auf Low-Pegel, wodurch sowohl der erste Summationspunkt der zweiten Stufe $H_N$ als auch derjenige der letzten Stufe $H_{N+1}$ auf ein Potential von -18 V gezogen werden, weshalb der zweite Transistor $T_{2,N}$ der zweiten Stufe $H_N$ in den sperrenden Zustand übergeht und gleichzeitig wegen des Taktwechsels der zweite Summationspunkt $X_{2,N}$ der zweiten Stufe $H_N$ auf ein Potential von -16,5 V aufsteigt. Demzufolge weist der erste Transistor $T_{1,N}$ der zweiten Stufe $H_N$ eine Gate-Source-Spannung von 1,5 V auf, die ihn in den leitenden Zustand steuert. Es erfolgt nun ein Ladungstransport von dem Pumpkondensator $C_N$ auf den Pumpkondensator $C_{N+1}$, wobei der erste Transistor $T_{1,N+1}$ der letzten Stufe $H_{N+1}$ sperrt, da der zweite Transistor $T_{2,N+1}$ dieser Stufe $H_{N+1}$ leitend ist und somit eine Gate-Source-Spannung von 0 V für diesen ersten Transistor $T_{1,N+1}$ erzeugt.

Nach einer weiteren Taktphase gehen die Taktsignale $\phi$ und $\phi_B$ wieder auf Low-Pegel und die Taktsignale und $\overline{\phi}$ und $\overline{\phi}_B$ wieder auf High-Pegel. Hierdurch wird der erste Summationspunkt $X_{1,N}$ der zweiten Stufe $H_N$ auf ein Potential von -16 V gezogen und derjenige der letzten Stufe $H_{N+1}$ auf -20 V; dies erzeugt für den zweiten Transistor $T_{2,N}$ der zweiten Stufe $H_N$ eine Gate-Source-Spannung von 4 V, wodurch er in den leitenden Zustand schaltet. Dies bewirkt, daß das Potential von -20 V an der Source-Elektrode des ersten Transistors $T_{1,N}$ auf den zweiten Summationspunkt $X_{2,N}$ der zweiten Stufe $H_N$ übertragen wird, wodurch dieser erste Transistor eine Gate-Source-Spannung von 0 V aufweist und daher in den sperrenden Zustand übergeht, während das Potential von -20 V des ersten Summationspunktes $X_{1,N+1}$ über den leitenden ersten Transistor $X_{1,N+1}$ der gleichen Stufe auf den Ausgang $V_{HV}$ oder eine nächste Stufe übertragen wird.

Falls entlang der Spannungsvervielfacherschaltung Spannungen abgegriffen werden sollen, die kleiner als die Ausgangsspannung $V_{HV}$ sind, kann dies gemäß Figur 4 durchgeführt werden. Dort ist nur die N-te Stufe der Spannungsvervielfacherschaltung gemäß Figur 2 dargestellt, an der eine Zwischenspannung abgegriffen werden soll. Dies erfolgt durch einen vierten Transistor $T_{4,N}$, dessen Source-Elektrode mit dem ersten Summationspunkt $X_{1,N}$ verbunden ist und dessen Gate-Elektrode an die Gate-Elektrode des ersten Transistors $T_{1,N}$ angeschlossen ist. Die Zwischenspannung ist an der Drain-Elektrode dieses vierten Transistors $T_{4,N}$ abgreifbar. Dieser vierte Transistor $T_{4,N}$ ist genau dann leitend, wenn auch der erste Transistor $T_{1,N}$ leitend ist.

Die zuvor beschriebenen Ausführungsbeispiele einer erfindungsgemäßen Spannungsvervielfacherschaltung können mit Vorteil beispielsweise auf einem Chip mit EEPROM-Zellen integriert werden.

**Patentansprüche**

1. Spannungsvervielfacherschaltung mit mehreren jeweils aus einem ersten und zweiten MOS-Transistor ($T_{1,N}$, $T_{2,N}$) und einem ersten und zweiten Kondensator ($C_N$, $C_{B,N}$) bestehenden Stufen ($H_N$), wobei ein direkt mit der Source-Elektrode des ersten MOS-Transistors ($T_{1,N}$) verbundener erster Summationspunkt ($X_{1,N}$) über den ersten Kondensator ($C_N$) an eine ein erstes Taktsignal ($\phi$, $\overline{\phi}$) liefernde erste Taktleitung ($L_{1,N}$) und ein die Gate-Elektrode des ersten MOS-Transistors ($T_{1,N}$) direkt mit der Drain-Elektrode des zweiten MOS-Transistors ($T_{2,N}$) verbindenden zweiten Summationspunkt ($X_{2,N}$) über den zweiten Kondensator ($C_{B,N}$) an eine ein zweites Taktsignal ($\phi_B$, $\overline{\phi}_B$) liefernde zweite Taktleitung ($L_{2,N}$) angeschlossen ist und benachbarte Stufen ($H_N$, $H_{N+1}$) über den ersten Summationspunkt ($X_{1,N+1}$) der einen Stufe ($H_{N+1}$) mit der Drain-Elektrode des ersten MOS-Transistors ($T_{1,N}$) der anderen Stufe ($H_N$) verbunden ist, dadurch gekennzeichnet, daß die Gate-Elektrode des zweiten MOS-Transistors ($T_{2,N+1}$) der einen Stufe ($H_{N+1}$) mit der Gate-Elektrode des ersten MOS-Transistors ($T_{1,N}$) der anderen Stufe ($H_N$) verbunden ist, daß jede Stufe ($H_N$) zum Sperren des ersten MOS-Transistors ($T_{1,N}$) einen dritten MOS-Transistor ($T_{3,N}$) sowie einen dritten MOS-Kondensator ($C_{K,N}$) aufweist, wobei die Gate- und die Source-Elektrode dieses dritten MOS-Transistors ($T_{3,N}$) jeweils auf dem gleichen Potential wie die Gate- und Source-Elektrode des ersten MOS-Transistors ($T_{1,N}$) liegen und der dritte MOS-Kondensator ($C_{K,N}$) so geschaltet ist, daß seine gespeicherte Ladung so lange über den ersten MOS-Transistor ($T_{1,N}$) abfließen kann, bis über dessen Source-Drain-Strecke eine Spannungsdifferenz abfällt, deren Wert der Summe der Schwellspannung und der Schwellspannungsverschiebung des ersten MOS-Transistors ($T_{1,N}$) entspricht oder diese Summe geringfügig unterschreitet.

2. Spannungsvervielfacherschaltung nach Anspruch 1, dadurch gekennzeichnet, daß die Source-Elektrode des dritten MOS-Transistors ($T_{3,N}$) mit dem ersten Summationspunkt ($X_{1,N}$), dessen Gate-Elektrode mit dem zweiten Summationspunkt ($X_{2,N}$) und dessen Drain-Elektrode über einen dritten Summationspunkt ($X_{3,N}$) mit der Source-Elektrode des zweiten MOS-Transistors ($T_{2,N}$) verbunden ist und daß der dritte Summationspunkt ($X_{3,N}$) über den dritten Kondensator ($C_{K,N}$) an eine Korrektursignalleitung ($L_{K,N}$) angeschlossen ist.

3. Spannungsvervielfacherschaltung nach Anspruch 2, dadurch gekennzeichnet, daß die Korrektursignalleitung ($L_{K,N}$) mit einem konstanten Betriebsspannungspotential ($V_{DD}$) beaufschlagt ist.

4. Spannungsvervielfacherschaltung nach Anspruch 2, dadurch gekennzeichnet, daß die Korrektursignalleitung ($L_{K,N}$) mit der ersten Taktsignalleitung ($L_{1,N}$) verbunden ist und mit dem ersten Taktsignal ($\phi$) beaufschlagt wird, das zu dem Taktsignal ($\overline{\phi}$), das den ersten Kondensator ($C_N$) ansteuert, gegenphasig ist.

5. Spannungsvervielfacherschaltung nach einem der Ansprüche 2 bis 4, dadurch gekennzeichnet, daß zum Abgriff einer Zwischenspannung entlang der Spannungsvervielfacherschaltung die entsprechende Stufe einen vierten MOS-Transistor ($T_{4,N}$) aufweist, daß die Source-Elektrode des vierten MOS-Transistors ($T_{4,N}$) mit dem ersten Summationspunkt ($X_{1,N}$), dessen Gate-Elektrode mit dem zweiten Summationspunkt ($X_{2,N}$) verbunden ist, und daß die Zwischenspannung an der Drain-Elektrode des vierten MOS-Transistors ($T_{4,N}$) abgreifbar ist.

6. Spannungsvervielfacherschaltung nach einem der vorangehenden Ansprüche, dadurch gekennzeichnet, daß die MOS-Transistoren ($T_{1,N}$, $T_{2,N}$ und $T_{3,N}$) vom p-Kanaltyp sind.

7. Spannungsvervielfacherschaltung nach einem der Ansprüche 1 bis 5, dadurch gekennzeichnet, daß die MOS-Transistoren ($T_{1,N}$, $T_{2,N}$ und $T_{3,N}$) vom n-Kanaltyp sind.

8. Spannungsvervielfacherschaltung mit mehreren jeweils aus einem ersten und zweiten MOS-Transistor ($T_{1,N}$, $T_{2,N}$) und einem ersten und zweiten Kondensator ($C_N$, $C_{B,N}$) bestehenden Stufen ($H_N$), wobei ein direkt mit der Drain-Elektrode des ersten MOS-Transistors ($T_{1,N}$) verbundener erster Summationspunkt ($X_{1,N}$) über den ersten Kondensator ($C_N$) an eine ein erstes Taktsignal ($\phi$, $\overline{\phi}$) liefernde erste Taktleitung ($L_{1,N}$) und ein die Gate-Elektrode des ersten MOS-Transistors ($T_{1,N}$) direkt mit der Drain-Elektrode des zweiten MOS-Transistors ($T_{2,N}$) verbindenden zweiten Summationspunkt ($X_{2,N}$) über den zweiten Kondensator ($C_{B,N}$) an eine ein zweites Taktsignal ($\phi_B$, $\overline{\phi}_B$) liefernde zweite Taktleitung ($L_{2,N}$) angeschlossen ist und benachbarte Stufen ($H_N$, $H_{N+1}$) über den ersten Summationspunkt ($X_{1,N+1}$) der einen Stufe ($H_{N+1}$) mit der Drain-Elektrode des ersten MOS-Transistors ($T_{1,N}$) der anderen Stufe ($H_N$) verbunden ist, dadurch gekennzeichnet, daß die MOS-Transistoren ($T_{1,N}$, $T_{2,N}$; $T_{1,N+1}$, $T_{2,N+1}$) der letzten n-Stufen ($H_N$, $H_{N+1}$), mit n $\geq$ 2 von einem ersten Kanaltyp sind, wobei die Gate-Elektroden der zweiten MOS-Transistoren ($T_{2,N}$, $T_{2,N+1}$) jeweils mit dem zugehörigen ersten Summationspunkt ($X_{1,N}$, $X_{1,N+1}$) und deren Source-Elektroden jeweils mit der Drain-Elektrode des zugehörigen ersten MOS-Transistors ($T_{1,N}$, $T_{1,N+1}$) verbunden sind und daß die den n letzten Stufen ($H_N$, $H_{N+1}$) vorgeschalteten Stufen ($H_{N-1}$) gemäß einem der Ansprüche 1 bis 5 mit Transistoren von einem zweiten Kanaltyp aufgebaut sind, wobei der Ausgang ($V_{HV}$) dieser vorgeschalteten Stufen ($H_{N-1}$) auf den ersten Summationspunkt ($X_{1,N}$) der nachfolgenden Stufe ($H_N$) geführt ist.

9. Spannungsvervielfacherschaltung nach Anspruch 8, dadurch gekennzeichnet, daß die Transistoren vom ersten Kanaltyp n-Kanal-Transistoren und die Transistoren vom zweiten Kanaltyp p-Kanal-Transistoren sind.

**Claims**

1. Voltage multiplier circuit including a plurality of stages ($H_N$) each comprising a first and second MOS transistor ($T_{1,N}$, $T_{2,N}$) and a first and second capacitor ($C_N$, $C_{B,N}$), wherein a first summing point ($X_{1,N}$) directly connected to the source electrode of the first MOS transistor ($T_{1,N}$) is connected via the first capacitor ($C_N$) to a first clock lead ($L_{1,N}$) delivering a first clock signal ($\phi$, $\overline{\phi}$) and a second summing point ($X_{2,N}$) directly connecting the gate electrode of the first MOS transistor ($T_{1,N}$) to the drain electrode of the second MOS transistor ($T_{2,N}$) is connected via the second capacitor ($C_{B,N}$) to a second clock lead ($L_{2,N}$) delivering a second clock signal ($\phi_B$, $\overline{\phi}_B$) and adjacent stages ($H_N$, $H_{N+1}$) is connected through the first summing point ($X_{1,N+1}$) of the one stage ($H_{N+1}$) with the drain electrode of the first MOS transistor ($T_{1,N}$) of the other stage ($H_N$), characterised in that, the gate electrode of the second MOS transistor ($T_{2,N+1}$) of the one stage ($H_{N+1}$) is connected to the gate electrode of the first MOS transistor ($T_{1,N}$) of the other stage ($H_N$), that each stage ($H_N$) has a third MOS transistor ($T_{3,N}$) and a third MOS capacitor ($C_{K,N}$) for blocking the first MOS transistor ($T_{1,N}$), where in the gate and the source electrode of this third MOS transistor ($T_{3,N}$) are at the same respective potential as the gate and source electrode of the first MOS transistor

$(T_{1,N})$ and the third MOS capacitor $(C_{K,N})$ is so connected that its stored charge can flow via the first MOS transistor $(T_{1,N})$ until such time as a voltage difference falls across its source - drain path whose value corresponds to the sum of the threshold voltage and of the threshold voltage displacement of the first MOS transistor $(T_{1,N})$ or falls slightly below this sum.

2. Voltage multiplier circuit in accordance with Claim 1, characterised in that, the source electrode of the third MOS transistor $(T_{3,N})$ is connected to the first summing point $(X_{1,N})$, its gate electrode is connected to the second summing point $(X_{2,N})$ and its drain electrode is connected via a third summing point $(X_{3,N})$ to the source electrode of the second MOS transistor $(T_{2,N})$ and that the third summing point $(X_{3,N})$ is connected via the third capacitor $(C_{K,N})$ to a correcting signal lead $(L_{K,N})$.

3. Voltage multiplier circuit in accordance with Claim 2, characterised in that, a constant operating voltage potential $(V_{DD})$ is applied to the correcting signal lead $(L_{K,N})$.

4. Voltage multiplier circuit in accordance with Claim 2, characterised in that, the correcting signal lead $(L_{K,N})$ is connected to the first clock signal lead $(L_{1,N})$ and there is applied to it the first clock signal $(\phi)$ which is of opposite phase to the clock signal $(\overline{\phi})$ that controls the first capacitor $(C_N)$.

5. Voltage multiplier circuit in accordance with any of the Claims 2 to 4, characterised in that, in order to tap off an intermediate voltage from the voltage multiplier circuit, the corresponding stage has a fourth MOS transistor $(T_{4,N})$, that the source electrode of the fourth MOS transistor $(T_{4,N})$ is connected to the first summing point $(X_{1,N})$, its gate electrode is connected to the second summing point $(X_{2,N})$ and that the intermediate voltage is derivable at the drain electrode of the fourth MOS transistor $(T_{4,N})$.

6. Voltage multiplier circuit in accordance with any of the preceding Claims, characterised in that, the MOS transistors $(T_{1,N}, T_{2,N}$ and $T_{3,N})$ are of the p channel type.

7. Voltage multiplier circuit in accordance with any of the Claims 1 to 5, characterised in that, the MOS transistors $(T_{1,N}, T_{2,N}$ and $T_{3,N})$ are of the n channel type.

8. Voltage multiplier circuit including a plurality of stages $(H_N)$ each comprising a first and second MOS transistor $(T_{1,N}, T_{2,N})$ and a first and second capacitor $(C_N, C_{B,N})$, wherein a first summing point $(X_{1,N})$ directly connected to the drain electrode of the first MOS transistor $(T_{1,N})$ is connected via the first capacitor $(C_N)$ to a first clock lead $(L_{1,N})$ delivering a first clock signal $(\phi, \overline{\phi})$ and a second summing point $(X_{2,N})$ directly connecting the gate electrode of the first MOS transistor $(T_{1,N})$ to the drain electrode of the second MOS transistor $(T_{2,N})$ is connected via the second capacitor $(C_{B,N})$ to a second clock lead $(L_{2,N})$ delivering a second clock signal $(\phi_B, \overline{\phi}_B)$ and adjacent stages $(H_N, H_{N+1})$ is connected through the first summing point $(X_{1,N+1})$ of the one stage $(H_{N+1})$ with the drain electrode of the first MOS transistor $(T_{1,N})$ of the other stage $(H_N)$, characterised in that, the MOS transistors $(T_{1,N}, T_{2,N}; T_{1,N+1}, T_{2,N+1})$ of the last n stages $(H_N, H_{N+1})$, where $n \geq 2$, are of a first channel type, wherein the gate electrodes of the second MOS transistors $(T_{2,N}, T_{2,N+1})$ are each connected to the appertaining first summing point $(X_{1,N}, X_{1,N+1})$ and their source electrodes are each connected to the drain electrode of the appertaining first MOS transistor $(T_{1,N}, T_{1,N+1})$ and that the stages $(H_{N-1})$ in accordance with any of the Claims 1 to 5 which are connected prior to the last n stages $(H_N, H_{N+1})$ are formed by transistors of a second channel type, wherein the output $(V_{HV})$ of these prior connected stages $(H_{N-1})$ is led to the first summing point $(X_{1,N})$ of the succeeding stage $(H_N)$.

9. Voltage multiplier circuit in accordance with Claim 8, characterised in that, the transistors of the first channel type are n channel transistors and the transistors of the second channel type are p channel transistors.

**Revendications**

1. Circuit multiplicateur de tension comprenant plusieurs étages $(H_N)$ constitués chacun d'un premier et d'un deuxième transistor MOS $(T_{1,N}, T_{2,N})$ et d'un premier eu d'un deuxième condensateur $(C_N, C_{B,N})$, dans lequel un premier point de sommation $(X_{1,N})$, relié directement à l'électrode de source du premier transistor MOS $(T_{1,N})$, est raccordé à travers le premier condensateur $(C_N)$ à une première ligne d'horloge $(L_{1,N})$ fournissant un premier signal d'horloge $(\phi, \overline{\phi})$ et un deuxième point de sommation $(X_{2,N})$, lequel relie l'électrode de grille du premier transistor MOS $(T_{1,N})$ directement à l'électrode de drain du deuxième transistor MOS $(T_{2,N})$, est raccordé à travers le deuxième condensateur $(C_{B,N})$ à une deuxième ligne d'horloge ($L_{2,N}$) fournissant un deuxième signal d'horloge ($\phi_B$, $\overline{\phi}_B$), et dans lequel des étages voisins ($H_N$, $H_{N+1}$) sont reliés entre eux par une liaison entre le premier point de sommation ($X_{1,N+1}$) d'un étage ($H_{N+1}$) et l'électrode de drain du premier transistor MOS ($T_{1,N}$) de l'autre étage ($H_N$), caractérisé en ce que l'électrode de grille du deuxième transistor MOS ($T_{2,N+1}$) de l'étage ($H_{N+1}$) mentionné en premier est reliée à l'électrode de grille du premier transistor MOS ($T_{1,N}$) de l'autre étage ($H_N$), et que chaque étage ($H_N$) comporte, pour le blocage du premier transistor MOS ($T_{1,N}$), un troisième transistor MOS ($T_{3,N}$) ainsi qu'un troisième condensateur MOS ($C_{K,N}$), les électrodes de grille et de source de ce troisième transistor MOS ($T_{3,N}$) se trouvant chaque fois au même potentiel que les électrodes de grille et de source du premier transistor MOS ($T_{1,N}$) et le troisième condensateur MOS ($C_{K,N}$) étant connecté de manière que la charge accumulée en lui puisse se dissiper à travers le premier transistor MOS ($T_{1,N}$) jusqu'à ce qu'apparaisse, aux bornes du circuit source-drain de ce transistor, une différence ou chute de tension dont la valeur correspond à la somme de la tension seuil et du décalage de la tension seuil du premier transistor MOS ($T_{1,N}$) ou est légèrement inférieure à cette somme.

2. Circuit multiplicateur de tension selon la revendication 1, caractérisé en ce que l'électrode de source du troisième transistor MOS ($T_{3,N}$) est reliée au premier point de sommation ($X_{1,N}$), l'électrode de grille de ce transistor est reliée au deuxième point de sommation ($X_{2,N}$) et son électrode de drain est reliée à travers un troisième point de sommation ($X_{3,N}$) à l'électrode de source du deuxième transistor MOS ($T_{2,N}$), et que le troisième point de sommation ($X_{3,N}$) est raccordé à travers le troisième condensateur ($C_{K,N}$) à une ligne de signal correcteur ($L_{K,N}$).

3. Circuit multiplicateur de tension selon la revendication 2, caractérisé en ce qu'un potentiel de tension de service constant ($V_{DD}$) est appliqué à la ligne de signal correcteur ($L_{K,N}$).

4. Circuit multiplicateur de tension selon la revendication 2, caractérisé en ce que la ligne de signal correcteur ($L_{K,N}$) est reliée à la première ligne de signal d'horloge ($L_{1,N}$) et reçoit le premier signal d'horloge ($\phi$), lequel est en opposition de phase avec le signal d'horloge ($\overline{\phi}$) qui commande le premier condensateur ($C_N$).

5. Circuit multiplicateur de tension selon une des revendications 2 à 4, caractérisé en ce que, pour le prélèvement d'une tension intermédiaire le long du circuit multiplicateur de tension, l'étage concerné comporte un quatrième transistor MOS ($T_{4,N}$), que l'électrode de source du quatrième transistor MOS ($T_{4,N}$) est reliée au premier point de sommation ($X_{1,N}$) et son électrode de grille est reliée au deuxième point de sommation ($X_{2,N}$), et que la tension intermédiaire peut être prélevée sur l'électrode de drain du quatrième transistor MOS ($T_{4,N}$).

6. Circuit multiplicateur de tension selon une des revendications précédentes, caractérisé en ce que les transistors MOS ($T_{1,N}$, $T_{2,N}$ et $T_{3,N}$) sont du type à canal p.

7. Circuit multiplicateur de tension selon une des revendications 1 à 5, caractérisé en ce que les transistors MOS ($T_{1,N}$, $T_{2,N}$ et $T_{3,N}$) sont du type à canal n.

8. Circuit multiplicateur de tension comprenant plusieurs étages ($H_N$) constitués chacun d'un premier et d'un deuxième transistor MOS ($T_{1,N}$, $T_{2,N}$) et d'un premier et d'un deuxième condensateur ($C_N$, $C_{B,N}$), dans lequel un premier point de sommation ($X_{1,N}$), relié directement à l'électrode de drain du premier transistor MOS ($T_{1,N}$), est raccordé à travers le premier condensateur ($C_N$) à une première ligne d'horloge ($L_{1,N}$) fournissant un premier signal d'horloge ($\phi$, $\overline{\phi}$) et un deuxième point de sommation ($X_{2,N}$), lequel relie l'électrode de grille du premier transistor MOS ($T_{1,N}$) directement à l'électrode de drain du deuxième transistor MOS ($T_{2,N}$), est raccordé à travers le deuxième condensateur ($C_{B,N}$) à une deuxième ligne d'horloge ($L_{2,N}$) fournissant un deuxième signal d'horloge ($\phi_B$, $\overline{\phi}_B$), et dans lequel des étages voisins ($H_N$, $H_{N+1}$) sont reliés entre eux par une liaison entre le premier point de sommation ($X_{1,N+1}$) d'un étage ($H_{N+1}$) et l'électrode de drain du premier transistor MOS ($T_{1,N}$) de l'autre étage ($H_N$), caractérisé en ce que les transistors MOS ($T_{1,N}$, $T_{2,N}$; $T_{1,N+1}$, $T_{2,N+1}$) des derniers n étages ($H_N$, $H_{N+1}$), où $n \geq 2$, sont d'un premier type de canal, les électrodes de grille des deuxièmes transistors MOS ($T_{2,N}$, $T_{2,N+1}$) étant reliées chaque fois au premier point de sommation ($X_{1,N}$, $X_{1,N+1}$) correspondant et les électrodes de source de ces deuxièmes transistors étant reliées chaque fois à l'électrode de drain du premier transistor MOS ($T_{1,N}$, $T_{1,N+1}$) correspondant, et que les étages ($H_{N-1}$) montés avant les derniers n étages ($H_N$, $H_{N+1}$) sont réalisés, selon une des revendications 1 à 5, avec des transistors d'un second type de canal, la sortie ($V_{HV}$) de ces étages ($H_{N-1}$) prévus en amont étant connectée au premier point de sommation ($X_{1,N}$) de l'étage ($H_N$) suivant.

9. Circuit multiplicateur de tension selon la revendication 8, caractérisé en ce que les transistors du premier type de canal sont des transistors à canal n et les transistors du second type de canal sont des transistors à canal p.

FIG.1

FIG.2

EP 0 389 846 B1

FIG.3

FIG.4

FIG. 5